# EUROPEAN PATENT APPLICATION

(11) **EP 4 009 521 A1**
(43) Date of publication of application: **08.06.2022**
(21) Application number: 21207863.8
(22) Date of filing: 11.11.2021
(51) Int. Cl.: H03H 11/20, H03H 11/22, H03H 7/20, H03H 7/21, H03K 5/15

(54) **FILTER CIRCUIT USING POLYPHASE FILTER WITH DYNAMIC RANGE ENHANCEMENT**

(30) Priority: 03.12.2020 US 202063120756 P; 18.10.2021 US 202117503385
(71) Applicant: MEDIATEK INC., Hsin-Chu 300 (TW)
(72) Inventor: LEE, Fong-Wen, 30078 Hsinchu City (TW); WANG, Wen-Chieh, 30078 Hsinchu City (TW); LIN, Yu-Hsin, 30078 Hsinchu City (TW)
(74) Representative: Haseltine Lake Kempner LLP

(57) **Abstract**

A filter circuit includes a polyphase filter (200) used to generate a plurality of output signals (Iₚ,Iₙ,Qₚ,Qₙ) with different phases according to a plurality of input signals (Vip,Vin). The polyphase filter includes a switch circuit (MN1) and a feed-forward capacitor (C_ff1). The switch circuit has a control terminal (N12) used to receive a control voltage, a first connection terminal used to output one of the output signals, and a second connection terminal (N11) used to receive one of the input signals. The feed-forward capacitor has a first plate coupled to the second connection terminal of the switch circuit and a second plate coupled to the control terminal of the switch circuit. The variable resistance of the switch is used as resistor in the RC polyphase structure. The feed-forward capacitor is used for continuous time bootstrapping of the switch circuit such that the resistance of the switch is not influenced by the signal swing of the input signal. The feed-forward capacitor together with a bias resistor at the control terminal of the switch circuit forms a high-pass filter for coupling the input signal to the control terminal.

## Description

This application claims the benefit of U.S. provisional application No. 63/120,756, filed on 12/03/2020 and incorporated herein by reference.

### Background

The present invention relates to a filter design, and more particularly, to a filter circuit using a polyphase filter with dynamic range enhancement.

A conventional passive polyphase filter includes a circuit constructed in a ring shape using four resistors and four capacitors, wherein the resistors and the capacitors are alternately connected in series. In addition, the conventional passive polyphase filter includes first and second input terminals and first through fourth output terminals, wherein an input signal with a predetermined frequency is differentially received by the first input terminal and the second input terminal, and four output signals with the same predetermined frequency but different phases are outputted from the first through fourth output terminals, respectively. However, the resistors may have the same resistance value that is deviated from a nominal value due to certain factors, and/or the capacitors may have the same capacitance value that is deviated from a nominal value due to certain factors. As a result, the output signals of the conventional passive polyphase filter suffer from a phase error introduced by imperfection of resistors and/or capacitors. There is a need for an innovative polyphase filter design that is capable of calibrating the phase error with less impact on the filter performance.

### Summary

One of the objectives of the claimed invention is to provide a filter circuit using a polyphase filter with dynamic range enhancement. One of the benefits of using the proposed polyphase filter with dynamic range enhancement is that the phase error at the polyphase filter outputs can be calibrated without introducing degradation of the filter performance.

According to a first aspect of the present invention, an exemplary filter circuit is disclosed. The exemplary filter circuit includes a polyphase filter arranged to generate a plurality of output signals with different phases according to a plurality of input signals. The polyphase filter includes a switch circuit and a feed-forward capacitor. The switch circuit has a control terminal arranged to receive a control voltage, a first connection terminal arranged to output one of the output signals, and a second connection terminal arranged to receive one of the input signals. The feed-forward capacitor has a first plate coupled to the second connection terminal of the switch circuit and a second plate coupled to the control terminal of the switch circuit.

According to a second aspect of the present invention, an exemplary filter circuit is disclosed. The exemplary filter circuit includes a polyphase filter arranged to generate a plurality of output signals with different phases according to a plurality of input signals. The polyphase filter includes a continuous-time bootstrapped switch circuit, having a control terminal arranged to receive a control voltage, a first connection terminal arranged to output one of the output signals, and a second connection terminal arranged to receive one of the input signals.

According to a third aspect of the present invention, an exemplary filter circuit is disclosed. The exemplary filter circuit includes a polyphase filter arranged to generate a plurality of output signals with different phases according to a plurality of input signals. The polyphase filter includes a switch circuit and a high-pass filter. The switch circuit has a control terminal arranged to receive a control voltage, a first connection terminal arranged to output one of the output signals, and a second connection terminal arranged to receive one of the input signals. The high-pass filter has an input port coupled to the second connection terminal of the switch circuit and an output port coupled to the control terminal of the switch circuit, and arranged to apply high-pass filtering to said one of the input signals for generating a filter output at the output port, wherein the filter output is involved in setting the control voltage.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a diagram illustrating a filter circuit with phase error calibration according to an embodiment of the present invention.
FIG. 2 is a diagram illustrating a polyphase filter with dynamic range enhancement according to an embodiment of the present invention.
FIG. 3 is a diagram illustrating a filter circuit using the polyphase filter shown in FIG. 2 according to an embodiment of the present invention.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

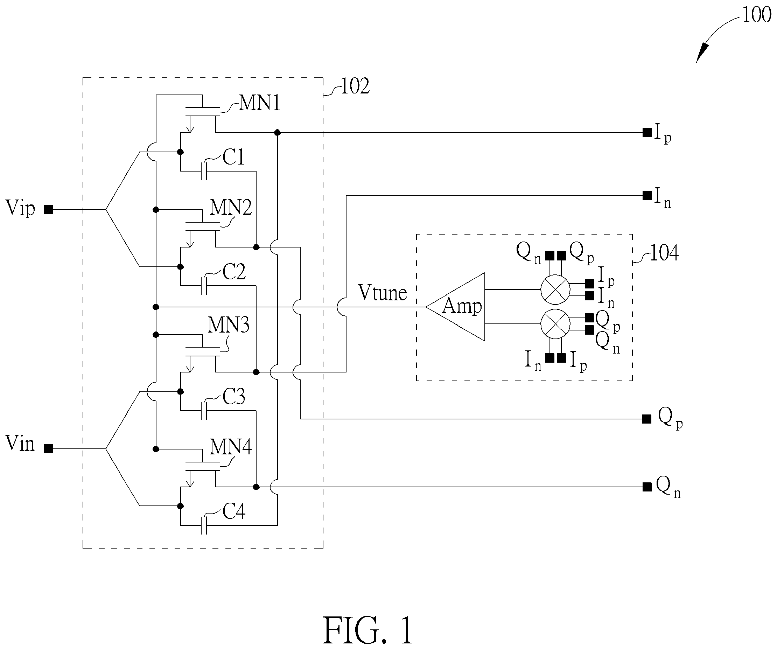

FIG. 1 is a diagram illustrating a filter circuit with phase error calibration according to an embodiment of the present invention. The filter circuit 100 includes a polyphase filter 102 and a phase detector 104. The polyphase filter 102 is a circuit designed to generate a plurality of output signals Iₚ, Iₙ, Qₚ, Qₙ with different phases according to a plurality of input signals Vip and Vin. Ideally, when the input signals Vip and Vin form a differential input (i.e. the input signals Vip and Vin have a **180°** phase difference therebetween), the output signals Iₚ, Iₙ, Qₚ, Qₙ are quadrature signals, such that the output signals Iₚ and Qₚ have a **90°** phase difference therebetween, the output signals Iₙ and Qₙ have a **90°** phase difference therebetween, the output signals Qₚ and Iₙ have a **90°** phase difference therebetween, and the output signals Qₙ and Iₚ have a 90° phase difference therebetween.

As shown in FIG. 1, the polyphase filter 102 is an active polyphase filter including a plurality of capacitors C1, C2, C3, C4
and a plurality of switch circuits implemented by metal-oxide-semiconductor (MOS) transistors such as N-channel metal-oxide-semiconductor (NMOS) transistors MN1, MN2, MN3, MN4. Each of the NMOS transistors MN1-MN4 is used to act as a resistor when being turned on by a control voltage at a control terminal (i.e. a gate voltage at a gate terminal) . Since the active polyphase filter architecture is known to those skilled in the pertinent art, further description is omitted here for brevity.

To address the phase error issue encountered by the polyphase filter 102, the filter circuit 100 includes the phase detector 104 that is a circuit designed to generate a tuning voltage Vtune in response to a phase error of the output signals Iₚ, Iₙ, Qₚ, Qₙ, wherein the same tuning voltage Vtune is supplied to gate terminals of the NMOS transistors MN1-MN4 for tuning the gate voltages of the NMOS transistors MN1-MN4. Since an on-resistance Rₒₙ of an NMOS transistor depends on a gate-source voltage of the NMOS transistor, tuning the control voltages (i.e. gate voltages) of the NMOS transistors MN1-MN4 can achieve the objective of adjusting the on-resistance Rₒₙ of each of the NMOS transistors MN1-MN4. In this way, the phase error of the output signals Iₚ, Iₙ, Qₚ, Qₙ can be reduced or cancelled by properly controlling the tuning voltage Vtune.

However, the tuning voltage Vtune applied to the gate terminals of the NMOS transistors MN1-MN4 prevents any of the input signals Vip and Vin from having a rail-to-rail dynamic range, which degrades the jitter performance of the polyphase filter 102. For example, the NMOS switch needs to be turned on for providing an on-resistance when the input signal Vip (or Vin) has a logic high level. Hence, the highest voltage of the input signal Vip (or Vin) fails to reach the supply voltage VDD. To address this issue, the present invention proposes a polyphase filter with dynamic range enhancement.

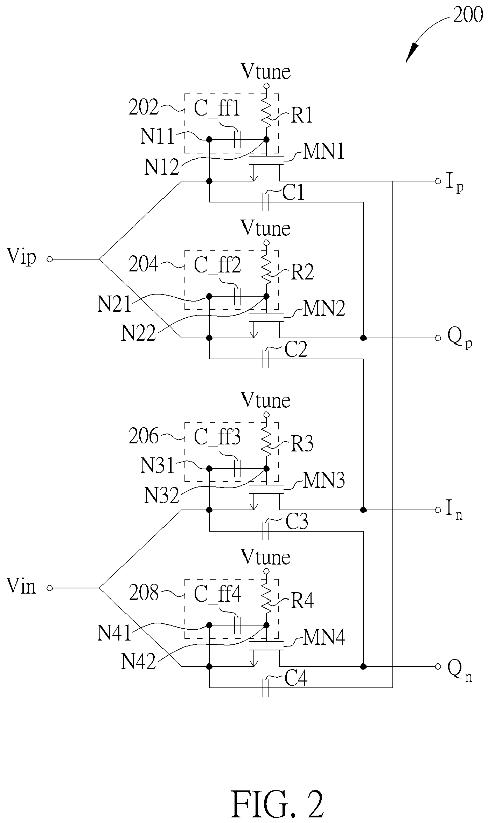

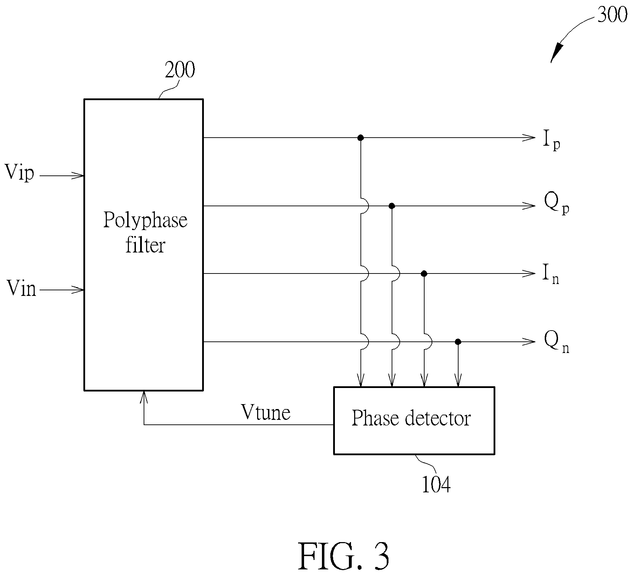

Please refer to FIG. 2 in conjunction with FIG. 3. FIG. 2 is a diagram illustrating a polyphase filter with dynamic range enhancement according to an embodiment of the present invention. FIG. 3 is a diagram illustrating a filter circuit using the polyphase filter shown in FIG. 2 according to an embodiment of the present invention. The filter circuit 100 shown in FIG. 1 may be modified to have the polyphase filter 102 replaced with the polyphase filter 200 to benefit from a dynamic range enhancement technique employed by the polyphase filter 200. Taking the embodiment shown in FIG. 3 for example, the filter circuit 300 includes the proposed polyphase filter 200 shown in FIG. 2 and the phase detector 104 shown in FIG. 1. The major difference between the polyphase filters 102 and 200 is that additional circuit elements, including feed-forward capacitors C_ff1, C_ff2, C_ff3, C_ff4 and resistors R1, R2, R3, R4, are employed by the polyphase filter 200.

The proposed polyphase filter 200 is an active polyphase filter having switch circuits implemented by MOS transistors such as NMOS transistors MN1, MN2, MN3, MN4, where each of the NMOS transistors MN1-MN4 possesses an on-resistance Rₒₙ when being turned on by a control voltage (gate voltage). In other words, resistors needed by the polyphase filter 200 can be realized by the turned-on NMOS switches. Regarding the NMOS transistor MN1, it has a control terminal (i.e. gate terminal), a first connection terminal (i.e. drain terminal), and a second connection terminal (i.e. source terminal), wherein the first connection terminal (i.e. drain terminal) is arranged to generate and output the output signal Iₚ, and the second connection terminal (i.e. source terminal) is arranged to receive the input signal Vip. The feed-forward capacitor C_ff1 has a first plate N11 coupled to the second connection terminal (i.e. source terminal) of the NMOS transistor MN1, and has a second plate N12 coupled to the control terminal (i.e. gate terminal) of the NMOS transistor MN1. In addition, the resistor R1 is coupled between the tuning voltage Vtune and the control terminal (i.e. gate terminal) of the NMOS transistor MN1. Specifically, the resistor R1 has one end for receiving the tuning voltage Vtune and the other end coupled to the control terminal (i.e. gate terminal) of the NMOS transistor MN1.

Regarding the NMOS transistor MN2, it has a control terminal (i.e. gate terminal), a first connection terminal (i.e. drain terminal), and a second connection terminal (i.e. source terminal), wherein the first connection terminal (i.e. drain terminal) is arranged to generate and output the output signal Qₚ, and the second connection terminal (i.e. source terminal) is arranged to receive the input signal Vip. The feed-forward capacitor C_ff2 has a first plate N21 coupled to the second connection terminal (i.e. source terminal) of the NMOS transistor MN2, and has a second plate N22 coupled to the control terminal (i.e. gate terminal) of the NMOS transistor MN2. In addition, the resistor R2 is coupled between the tuning voltage Vtune and the control terminal (i.e. gate terminal) of the NMOS transistor MN2. Specifically, the resistor R2 has one end for receiving the tuning voltage Vtune and the other end coupled to the control terminal (i.e. gate terminal) of the NMOS transistor MN2.

Regarding the NMOS transistor MN3, it has a control terminal (i.e. gate terminal), a first connection terminal (i.e. drain terminal), and a second connection terminal (i.e. source terminal), wherein the first connection terminal (i.e. drain terminal) is arranged to generate and output the output signal Iₙ, and the second connection terminal (i.e. source terminal) is arranged to receive the input signal Vin. The feed-forward capacitor C_ff3 has a first plate N31 coupled to the second connection terminal (i.e. source terminal) of the NMOS transistor MN3, and has a second plate N32 coupled to the control terminal (i.e. gate terminal) of the NMOS transistor MN3. In addition, the resistor R3 is coupled between the tuning voltage and the control terminal (i.e. gate terminal) of the NMOS transistor MN3. Specifically, the resistor R3 has one end for receiving the tuning voltage Vtune and the other end coupled to the control terminal (i.e. gate terminal) of the NMOS transistor MN3.

Regarding the NMOS transistor MN4, it has a control terminal (i.e. gate terminal), a first connection terminal (i.e. drain terminal), and a second connection terminal (i.e. source terminal), wherein the first connection terminal (i.e. drain terminal) is arranged to generate and output the output signal Qₙ, and the second connection terminal (i.e. source terminal) is arranged to receive the input signal Vin. The feed-forward capacitor C_ff4 has a first plate N41 coupled to the second connection terminal (i.e. source terminal) of the NMOS transistor MN4, and has a second plate N42 coupled to the control terminal (i.e. gate terminal) of the NMOS transistor MN4. In addition, the resistor R4 is coupled between the tuning voltage and the control terminal (i.e. gate terminal) of the NMOS transistor MN4. Specifically, the resistor R4 has one end for receiving the tuning voltage Vtune and the other end coupled to the control terminal (i.e. gate terminal) of the NMOS transistor MN4.

In this embodiment, all of the feed-forward capacitors C_ff1-C_ff4 may have the same capacitance value C_{HPF}, that is, C_eff1=C_eff2=C_eff3=C_eff1=C_{HPF}, and all of the resistors R1-R4 may have the same resistance value R_{HPF}, that is, R1=R2=R3=R4=R_{HPF}. In some embodiments of the present invention, the input signals Vip and Vin form a differential input and therefore have a **180°** phase difference therebetween, and/or the input signals Vip and Vin may be clock signals (e.g. local oscillator (LO) signals) generated from a clock generator. Hence, in a wireless communication application, the polyphase filter 200 may be used to generate the output signals Iₚ, Iₙ, Qₚ, Qₙ as LO signals with different phases. For example, the input signals Vip and Vin may be a differential LO signal, the output signal Iₚ may serve as an LO signal with a **0°** phase, the output signal Qₚ may serve as an LO signal with a **90°** phase, the output signal Iₙ may serve as an LO signal with a **180°** phase, and the output signal Qₙ may serve as an LO signal with a **270°** phase.

A high-pass filter 202 is formed by the feed-forward capacitor C_ff1 and the resistor R1. The high-pass filter 202 has an input port (i.e. first plate N11 of feed-forward capacitor C1) coupled to the second connection terminal (i.e. source terminal) of the NMOS transistor MN1 and an output port (i.e. second plate N12 of feed-forward capacitor C1) coupled to the control terminal (i.e. gate terminal) of the NMOS transistor MN1, and is arranged to apply high-pass filtering to the input signal Vip for generating a filter output at the output port N12. In this embodiment, the input signal Vip is a high-frequency signal such as an LO signal. Hence, the input signal Vip is passed to the output port N12 through the high-pass filter 202, and is involved in setting the control voltage at the control terminal (i.e. gate terminal) of the NMOS transistor MN1.

Similarly, a high-pass filter 204 is formed by the feed-forward capacitor C_ff2 and the resistor R2. The high-pass filter 204 has an input port (i.e. first plate N21 of feed-forward capacitor C2) coupled to the second connection terminal (i.e. source terminal) of the NMOS transistor MN2 and an output port (i.e. second plate N22 of feed-forward capacitor C2) coupled to the control terminal (i.e. gate terminal) of the NMOS transistor MN2, and is arranged to apply high-pass filtering to the input signal Vip for generating a filter output at the output port N22. In this embodiment, the input signal Vip is a high-frequency signal such as an LO signal. Hence, the input signal Vip is passed to the output port N22 through the high-pass filter 204, and is involved in setting the control voltage at the control terminal (i.e. gate terminal) of the NMOS transistor MN2.

A high-pass filter 206 is formed by the feed-forward capacitor C_ff3 and the resistor R3. The high-pass filter 206 has an input port (i.e. first plate N31 of feed-forward capacitor C3) coupled to the second connection terminal (i.e. source terminal) of the NMOS transistor MN3 and an output port (i.e. second plate N32 of feed-forward capacitor C3) coupled to the control terminal (i.e. gate terminal) of the NMOS transistor MN3, and is arranged to apply high-pass filtering to the input signal Vin for generating a filter output at the output port N32. In this embodiment, the input signal Vin is a high-frequency signal such as an LO signal. Hence, the input signal Vin is passed to the output port N32 through the high-pass filter 206, and is involved in setting the control voltage at the control terminal (i.e. gate terminal) of the NMOS transistor MN3.

A high-pass filter 208 is formed by the feed-forward capacitor C_ff4 and the resistor R4. The high-pass filter 208 has an input port (i.e. first plate N41 of feed-forward capacitor C4) coupled to the second connection terminal (i.e. source terminal) of the NMOS transistor MN4 and an output port (i.e. second plate N42 of feed-forward capacitor C4) coupled to the control terminal (i.e. gate terminal) of the NMOS transistor MN4, and is arranged to apply high-pass filtering to the input signal Vin for generating a filter output at the output port N42. In this embodiment, the input signal Vin is a high-frequency signal such as an LO signal. Hence, the input signal Vin is passed to the output port N42 through the high-pass filter 208, and is involved in setting the control voltage at the control terminal (i.e. gate terminal) of the NMOS transistor MN4.

With the use of feed-forward capacitors C_ff1-C_ff4, the NMOS transistors MN1-MN4 can be turned into continuous-time bootstrapped switch circuits. Specifically, the arrangement of the feed-forward capacitor C_ff1 bootstraps the gate voltage of the NMOS transistor MN1 to the source voltage of the NMOS transistor MN1, thus allowing the two voltages to change in unison. Since the tuning voltage Vtune is coupled to the control terminal (i.e. gate terminal) of the NMOS transistor MN1 via the resistor R1, the tuning voltage Vtune is also involved in setting the control voltage (gate voltage) of the NMOS transistor MN1. For example, the control voltage (gate voltage) of the NMOS transistor MN1 may be set by Vtune+Vip. Since the gate-source voltage V_{GS} is fixed at Vtune (i.e. V_{GS}=Vtune+Vip-Vip=Vtune) regardless of the voltage level of the input signal Vip, the on-resistance Rₒₙ of the NMOS transistor MN1 is kept constant, and the input signal Vip received by the NMOS transistor MN1 is allowed to have a rail-to-rail dynamic range.

Similarly, the arrangement of the feed-forward capacitor C_ff2 bootstraps the gate voltage of the NMOS transistor MN2 to the source voltage of the NMOS transistor MN2, thus allowing the two voltages to change in unison. Since the tuning voltage Vtune is coupled to the control terminal (i.e. gate terminal) of the NMOS transistor MN2 via the resistor R2, the tuning voltage Vtune is also involved in setting the control voltage (gate voltage) of the NMOS transistor MN2. For example, the control voltage (gate voltage) of the NMOS transistor MN2 may be set by Vtune+Vip. Since the gate-source voltage V_{GS} is fixed at Vtune (i.e. V_{GS}=Vtune+Vip-Vip=Vtune) regardless of the voltage level of the input signal Vip, the on-resistance Rₒₙ of the NMOS transistor MN2 is kept constant, and the input signal Vip received by the NMOS transistor MN2 is allowed to have a rail-to-rail dynamic range.

The arrangement of the feed-forward capacitor C_ff3 bootstraps the gate voltage of the NMOS transistor MN3 to the source voltage of the NMOS transistor MN3, thus allowing the two voltages to change in unison. Since the tuning voltage Vtune is coupled to the control terminal (i.e. gate terminal) of the NMOS transistor MN3 via the resistor R3, the tuning voltage Vtune is also involved in setting the control voltage (gate voltage) of the NMOS transistor MN3. For example, the control voltage (gate voltage) of the NMOS transistor MN3 may be set by Vtune+Vin. Since the gate-source voltage V_{GS} is fixed at Vtune (i.e. V_{GS}=Vtune+Vin-Vin=Vtune) regardless of the voltage level of the input signal Vin, the on-resistance Rₒₙ of the NMOS transistor MN3 is kept constant, and the input signal Vin received by the NMOS transistor MN3 is allowed to have a rail-to-rail dynamic range.

The arrangement of the feed-forward capacitor C_ff4 bootstraps the gate voltage of the NMOS transistor MN4 to the source voltage of the NMOS transistor MN4, thus allowing the two voltages to change in unison. Since the tuning voltage Vtune is coupled to the control terminal (i.e. gate terminal) of the NMOS transistor MN4 via the resistor R4, the tuning voltage Vtune is also involved in setting the control voltage (gate voltage) of the NMOS transistor MN4. For example, the control voltage (gate voltage) of the NMOS transistor MN4 may be set by Vtune+Vin. Since the gate-source voltage V_{GS} is fixed at Vtune (i.e. V_{GS}=Vtune+Vin-Vin=Vtune) regardless of the voltage level of the input signal Vin, the on-resistance Rₒₙ of the NMOS transistor MN4 is kept constant, and the input signal Vin received by the NMOS transistor MN4 is allowed to have a rail-to-rail dynamic range.

In the above embodiment, a filter circuit using the proposed polyphase filter with dynamic range enhancement may be employed by a clock generator such as a quadrature LO signal generator. However, this is for illustrative purposes only, and is not meant to be a limitation of the present invention. In practice, any application that adopts a filter circuit using the proposed polyphase filter with dynamic range enhancement falls within the scope of the present invention.

Those skilled in the art will readily observe that numerous modifications and alterations of the device and method may be made while retaining the teachings of the invention. Accordingly, the above disclosure should be construed as limited only by the metes and bounds of the appended claims.

The present invention may also be defined by means of the following numbered clauses.
1. A filter circuit comprising:
   a polyphase filter, arranged to generate a plurality of output signals with different phases according to a plurality of input signals,
   wherein the polyphase filter comprises:
      a switch circuit, having a control terminal arranged to receive a control voltage, a first connection terminal arranged to output one of the plurality of output signals, and a second connection terminal arranged to receive one of the plurality of input signals; and
      a feed-forward capacitor, having a first plate coupled to the second connection terminal of the switch circuit and a second plate coupled to the control terminal of the switch circuit.
2. The filter circuit of clause 1, further comprising:
   a phase detector, arranged to generate a tuning voltage in response to a phase error of the plurality of output signals;
   wherein the polyphase filter further comprises:
      a resistor, having a first end arranged to receive the tuning voltage and a second end coupled to the control terminal of the switch circuit, wherein the tuning voltage is involved in setting the control voltage.
3. The filter circuit of clause 1, wherein the plurality of input signals comprise a differential input.
4. The filter circuit of clause 1, wherein the plurality of input signals comprise clock signals.
5. The filter circuit of clause 1, wherein the switch circuit is a metal-oxide-semiconductor (MOS) transistor.
6. The filter circuit of clause 5, wherein the MOS transistor has a fixed on-resistance, regardless of a voltage level of said one of the plurality of input signals.
7. A filter circuit comprising:
   a polyphase filter, arranged to generate a plurality of output signals with different phases according to a plurality of input signals,
   wherein the polyphase filter comprises:
      a continuous-time bootstrapped switch circuit, having a control terminal arranged to receive a control voltage, a first connection terminal arranged to output one of the plurality of output signals, and a second connection terminal arranged to receive one of the plurality of input signals.
8. The filter circuit of clause 7, further comprising:
   a phase detector, arranged to generate a tuning voltage in response to a phase error of the plurality of output signals;
   wherein the polyphase filter further comprises:
      a resistor, having a first end arranged to receive the tuning voltage and a second end coupled to the control terminal of the continuous-time bootstrapped switch.
9. The filter circuit of clause 7, wherein the plurality of input signals comprise a differential input.
10. The filter circuit of clause 7, wherein the plurality of input signals comprise clock signals.
11. A filter circuit comprising:
   a polyphase filter, arranged to generate a plurality of output signals with different phases according to a plurality of input signals,
   wherein the polyphase filter comprises:
      a switch circuit, having a control terminal arranged to receive a control voltage, a first connection terminal arranged to output one of the plurality of output signals, and a second connection terminal arranged to receive one of the plurality of input signals; and
      a high-pass filter, having an input port coupled to the second connection terminal of the switch circuit and an output port coupled to the control terminal of the switch circuit, and arranged to apply high-pass filtering to said one of the plurality of input signals for generating a filter output at the output port, wherein the filter output is involved in setting the control voltage.
12. The filter circuit of clause 11, further comprising:
   a phase detector, arranged to generate a tuning voltage in response to a phase error of the plurality of output signals;
   wherein the tuning voltage is also involved in setting the control voltage.
13. The filter circuit of clause 11, wherein the plurality of input signals comprise a differential input.
14. The filter circuit of clause 11, wherein the plurality of input signals comprise clock signals.
15. The filter circuit of clause 11, wherein the switch circuit is a metal-oxide-semiconductor (MOS) transistor.
16. The filter circuit of clause 15, wherein the MOS transistor has a fixed on-resistance, regardless of a voltage level of said one of the plurality of input signals.

## Claims

1. A filter circuit (100) comprising:
a polyphase filter (102, 200), arranged to generate a plurality of output signals with different phases according to a plurality of input signals, wherein the polyphase filter (102, 200) comprises:
a switch circuit, having a control terminal arranged to receive a control voltage, a first connection terminal arranged to output one of the plurality of output signals, and a second connection terminal arranged to receive one of the plurality of input signals; and
a feed-forward capacitor (C_ff1, C_ff2, C_ff3, C_ff4), having a first plate coupled to the second connection terminal of the switch circuit and a second plate coupled to the control terminal of the switch circuit.

2. The filter circuit (100) of claim 1, further comprising:
a phase detector, arranged to generate a tuning voltage in response to a phase error of the plurality of output signals;
wherein the polyphase filter (102, 200) further comprises:
a resistor (R1, R2, R3, R4), having a first end arranged to receive the tuning voltage and a second end coupled to the control terminal of the switch circuit, wherein the tuning voltage is involved in setting the control voltage.

3. The filter circuit (100) of claim 1, wherein the plurality of input signals comprise a differential input.

4. The filter circuit (100) of claim 1, wherein the plurality of input signals comprise clock signals.

5. The filter circuit (100) of claim 1, wherein the switch circuit is a metal-oxide-semiconductor, MOS, transistor.

6. The filter circuit (100) of claim 5, wherein the MOS transistor has a fixed on-resistance, regardless of a voltage level of said one of the plurality of input signals.

7. A filter circuit (100) comprising:
a polyphase filter (102, 200), arranged to generate a plurality of output signals with different phases according to a plurality of input signals, wherein the polyphase filter (102, 200) comprises:
a continuous-time bootstrapped switch circuit, having a control terminal arranged to receive a control voltage, a first connection terminal arranged to output one of the plurality of output signals, and a second connection terminal arranged to receive one of the plurality of input signals.

8. The filter circuit (100) of claim 7, further comprising:
a phase detector, arranged to generate a tuning voltage in response to a phase error of the plurality of output signals;
wherein the polyphase filter (102, 200) further comprises:
a resistor (R1, R2, R3, R4), having a first end arranged to receive the tuning voltage and a second end coupled to the control terminal of the continuous-time bootstrapped switch.

9. The filter circuit (100) of claim 7, wherein the plurality of input signals comprise a differential input; or
wherein the plurality of input signals comprise clock signals.

10. A filter circuit (100) comprising:
a polyphase filter (102, 200), arranged to generate a plurality of output signals with different phases according to a plurality of input signals, wherein the polyphase filter (102, 200) comprises:
a switch circuit, having a control terminal arranged to receive a control voltage, a first connection terminal arranged to output one of the plurality of output signals, and a second connection terminal arranged to receive one of the plurality of input signals; and
a high-pass filter (202, 204, 206, 208), having an input port coupled to the second connection terminal of the switch circuit and an output port coupled to the control terminal of the switch circuit, and arranged to apply high-pass filtering to said one of the plurality of input signals for generating a filter output at the output port, wherein the filter output is involved in setting the control voltage.

11. The filter circuit (100) of claim 10, further comprising:
a phase detector (104), arranged to generate a tuning voltage in response to a phase error of the plurality of output signals;
wherein the tuning voltage is also involved in setting the control voltage.

12. The filter circuit (100) of claim 10, wherein the plurality of input signals comprise a differential input.

13. The filter circuit (100) of claim 10, wherein the plurality of input signals comprise clock signals.

14. The filter circuit of claim 10, wherein the switch circuit is a metal-oxide-semiconductor, MOS, transistor.

15. The filter circuit (100) of claim 14, wherein the MOS transistor has a fixed on-resistance, regardless of a voltage level of said one of the plurality of input signals.
